# EUROPEAN PATENT SPECIFICATION

(11) **EP 0 655 158 B1**
(45) Date of publication and mention of the grant of the patent: **29.12.1999**
(21) Application number: 93918035.2
(22) Date of filing: 16.08.1993
(51) Int. Cl.: G10L 3/02, H04M 9/08

(54) **METHOD AND APPARATUS FOR ATTENUATING AN UNWANTED AUDIO SIGNAL IN A MIX OF SIGNALS**
ANLAGE UND VERFAHREN ZUR VERRINGERUNG EINES UNERWÜNSCHTEN AUDIOSIGNALS IN EINER MISCHUNG VON SIGNALEN
PROCEDE ET DISPOSITIF D'ATTENUATION D'UN SIGNAL AUDIO INDESIRABLE DANS UN MELANGE DE SIGNAUX

(30) Priority: 14.08.1992 GB 9217313
(43) Date of publication of application: 31.05.1995
(73) Proprietor: BRITISH BROADCASTING CORPORATION, London W1A 1AA (GB)
(72) Inventor: KIRBY, David, Graham 21 Wallace Fields Ewell, Surrey KT17 3AX (GB); MASON, Andrew, James, Surrey SM5 2ST (GB)
(74) Representative: Abnett, Richard Charles
(86) International application number: GB9301738
(87) International publication number: WO9405006

(56) References cited:
- EP-A- 0 113 487
- EP-A- 0 515 242
- INTERNATIONAL CONFERENCE ON ACOUSTICS SPEECH AND SIGNAL PROCESSING vol. 5 , 14 May 1991 , TORONTO CANADA pages 3585 - 3588 AMANO, PEREZ 'A new subband echo canceller structure'
- INTERNATIONAL CONFERENCE ON ACOUSTICS SPEECH AND SIGNAL PROCESSING vol. 1 , 23 May 1989 , GLASGOW SCOTLAND U.K. pages 377 - 380 VASEGHI, RAYNER 'The effects of non-stationary signal characteristics on the performance of adaptive audio restoration systems'
- PROCCEDINGS OF THE IEEE vol. 63, no. 12 , December 1975 , NEW YORK USA pages 1692 - 1716 WIDROW ET AL 'Adaptive noise cancelling: Principles and applications' cited in the application

## Description

### FIELD OF THE INVENTION

This invention relates to a method and apparatus for attenuating an unwanted audio signal which is included in a mixed audio signal which comprises a contribution from the unwanted signal together with other signals.

This invention is particularly applicable to the fields of broadcasting and programme production, specifically to a method of removing an unwanted, given, audio component from a mix of signals, where the amplitude and time-offset of the given component in the mix are unknown and subject to variation.

### BACKGROUND OF THE INVENTION

It is common practice to supply a commentator at an outside broadcast event with a feed of the off-air programme to provide a cue signal. An announcer or studio presenter usually leads up to the contribution and introduces the commentator as part of the broadcast programme. The commentator hears this cue in the programme received off-air and starts to speak. A problem which then manifests itself is that the commentator hears his or her own voice in the off-air feed with the delay incurred by passing through the broadcast chain. This has been known to be so distracting as to render the commentator speechless.

This phenomenon currently causes problems in television (TV) and radio operations. However when Digital Audio Broadcasting (DAB) is introduced the delays introduced in the broadcast chain could be of the order of 500 ms (half a second), and this will cause an extremely distracting effect even for an experienced commentator.

A solution to the problem would be to provide the commentator with a feed of the programme signal prior to the addition of his own commentary, i.e. produced locally at the outside broadcast site. For many operational reasons this is not feasible, particularly when the programme has contributions from several sites, which the commentator would then not be able to hear.

The preferred solution to the problem would be to suppress the sound of the commentator in his personal feed of the programme which has been received off-air. As the commentary signal is available on its own at the originating site it can in principle be subtracted from the off-air feed, if it can be delayed by an appropriate amount and the correct gain applied to it to give cancellation in the off-air feed. In addition equalisation may have been applied to the commentary, either deliberately or as a consequence of being broadcast, and compensation may also have to be made for this.

Other instances may occur where it would be desirable to remove a component of a mix of signals, e.g. a mix of dialogue and sound effects. The dialogue alone is required. However if the sound effects are separately available, the clean dialogue could be recovered from the mix by subtracting them using the same techniques.

Whilst these problems can be partially addressed by known signal processing techniques, as employed, for example, in an adaptive signal canceller, there are additional problems encountered where there is an unknown relative delay between the mixed signal and the unwanted signal and in particular where this delay may be varying. We have appreciated that a major limitation of other techniques in this situation is that the potentially large relative delay involved would necessitate a long filter length to give adequate suppression of the unwanted signal. This would result in a more expensive solution and would have the additional drawback of requiring a longer time to adapt to the signals and achieve the required suppression.

The attenuation of unwanted signals can be performed by adaptive signal cancelling techniques; see generally "Adaptive Noise Cancellation : principles and applications", Proceedings of the IEEE, Vol. 63, No. 12, December 1975, Widrow et al.; note pages 1709 and 1710 (Appendix B) thereof.

European Patent Application EP-A-0 113 487 (equivalent United States Patent US-A-4,577,309) discloses an echo canceller for use in a satellite communications circuit and which measures distant echo delay and operates to effect cancellation of both near and distant echos. This uses a separate measurement phase to make the required measurement which is then employed until the transmission is interrupted to allow another measurement phase.

### SUMMARY OF THE INVENTION

The invention in its various aspects is defined in the independent claims below, to which reference should now be made. Advantageous preferred features of the invention are set forth in the appendant claims.

### BRIEF DESCRIPTION OF THE DRAWINGS

The invention will now be described in more detail by way of example with reference to the accompanying drawings, in which:
**Figure 1** is a block circuit diagram of a first signal attenuator embodying the invention;
**Figure 2** is a block circuit diagram of a second signal attenuator embodying the invention;
**Figures 3 and 4** are diagrams illustrating the operation of the attenuator of Figure 1; and
**Figure 5** is a block circuit diagram of a modification of the attenuator of Figure 1.

### DETAILED DESCRIPTION OF THE PREFERRED EMBODIMENTS

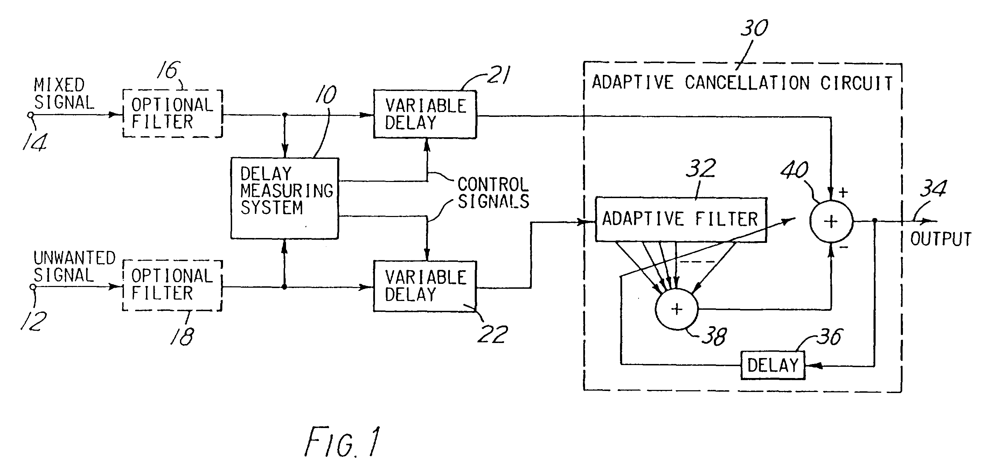

The preferred embodiment shown in Figure 1 uses a combination of delay measurement and adaptive signal cancellation. The attenuator operates with digital signals sampled at a frequency of the order of 48 kHz. A delay measuring system 10, which can be based on phase correlation techniques, is used to measure the delay between the unwanted signal received at an input 12 and its contribution present in the mixed signal received at an input 14. The system 10 can be based on the method described in "The Phase Correlation Image Alignment Method", Kuglin CD and Hines DC, Proceedings of the IEEE, International Conference on Cybernetics and Society, September 1975, pages 163 to 165. The measurement of delay is then used to control two audio delaying devices 21 and 22, which receive the mixed signal and the unwanted signal, respectively, and which are adjusted to delay the leading signal in order to co-time approximately the two signals. After being co-timed in this way, the unwanted signal and the mixed signal are applied to an adaptive cancellation circuit 30.

The adaptive cancellation circuit 30 automatically corrects for any remaining small delays between the signals, and has a filter 32, which may take the form of a transversal filter, to filter the unwanted signal prior to subtracting it from the mixed signal. To this end the signal at the output 34 of the adaptive cancellation circuit 30 is applied through a delay 36 to control the coefficients of the filter 32. The filter 32 is provided with a combining circuit 38, the output of which is applied to the inverting input of a subtractor 40 which receives the delayed mixed signal at its non-inverting input. The output of the subtractor 40 constitutes the circuit output 34.

This cancellation circuit 30 is adaptive and modifies its own operation in a conventional manner to minimise the level of the reference signal remaining in the mixed signal. The well-known LMS (least mean squares) adaption algorithm has been found to be satisfactory for this purpose although other techniques could be applied. For further details of adaptive signal cancellation reference may be made to the textbooks "Adaptive Signal Processing", Widrow, B. and Stearns, S.D., published by Prentice-Hall, 1985, ISBN 0-13-004029-0, see especially pages 302 - 306, and "Theory and Design of Adaptive Filters", Treichler, J.R., Johnson, C.R., and Larimore, M.G., published by John Wiley and Sons, 1987, ISBN 0-471-83220-0, see especially pages 229 - 233.

The use of an audio delay measurement system 10 and delays 21, 22 in this way allows a shorter filter 32 to be used in the adaptive canceller 30 which consequently reduces its cost and also ensures that the adaption operation is rapid and responsive to changes in the signals.

The system can be further improved by filtering the mixed and unwanted signals to eliminate components of the signals which are outside the frequency band of interest. Such filters are shown at 16 and 18 in dashed lines in Figure 1 and may be placed before or after the delays 21, 22. For example, the presence of DC components, which could be introduced by mis-aligned analogue-to-digital conversion equipment, can lead to poor suppression of the unwanted signal in the band of interest. By removing these components prior to the adaptive canceller 30 the suppression of the unwanted signal in the frequency band of interest is improved. Similarly, higher frequency components may be filtered out by band-pass or low-pass filters to ensure that the operation of the system is not perturbed by other elements of the signals which are not of concern.

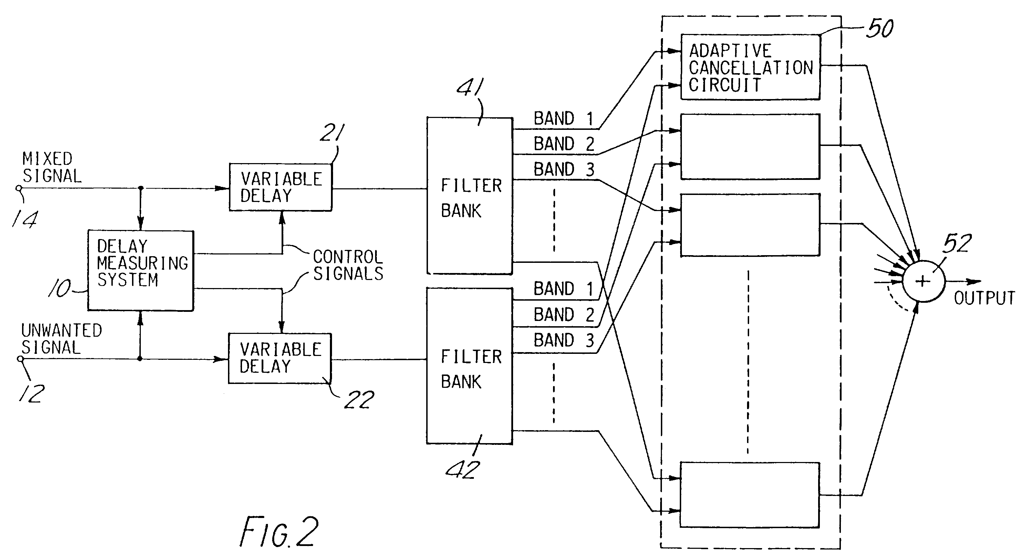

In order to cope with the situation where more severe phase or amplitude effects are being introduced, perhaps by filtering as part of the broadcast chain, it may be beneficial to employ several adaptive cancellation circuits operating in parallel as shown in Figure 2. In this arrangement two identical filter banks 41 and 42, or similar units, are employed to split the mixed and unwanted signals into several separate frequency bands, and are located after the delays 21, 22 to avoid the need to duplicate the delays. Each of the plurality of cancellation circuits 50 processes one of the frequency bands, and their outputs are summed in an adder 52. The advantage of this approach is that better suppression of the unwanted signal can be achieved in each of the individual bands where the filtering requirements of each band are significantly different.

A further problem arises when the delay through the broadcast chain is varying, as would be the case when the broadcast signals are passed through re-synchronising systems typically employed in broadcast centres. These devices co-time video signals by inserting a variable delay in the paths of the video and audio signals. This delay will vary depending on the instantaneous relative timing of the incoming video signal and the reference to which it is to be synchronised. In order to cater for this situation the delay measurement system 10 may be used to monitor changes in the relative delay of the mixed and unwanted signals. Small variations in this delay are of no concern as these are eliminated by the adaptive canceller. However, as the relative delay increases further, the adaptive canceller 30 will move towards one end of its range as imposed by the hardware implementation, i.e. the adaption will "move" the centre of the filter along the filter hardware, reducing its effectiveness as it nears one end. For extreme variations in relative delay the adaption will attempt to move the filter beyond the end of its range and the required cancellation will not occur.

This problem is overcome by using the delay measuring system 10 to vary the compensating audio delays 21, 22 as changes in the relative delay of the incoming signals are detected. When small changes in delay are detected the system makes no compensation adjustment until the aggregate of these changes may affect the effectiveness of the adaptive canceller 30. At this point the compensating audio delay could be changed inaudibly to match the new delay value and centre the adaptive canceller at the mid-point of its range.

An alternative method can be employed when the delays 21, 22 and adaptive canceller 30 are implemented together and share the same signal storage elements. It will be recalled that the adaptive filter 32, being a transversal filter, comprises a series of one-sample delays arranged to provide simultaneously a sequence of adjacent sample values, multipliers for multiplying the sample values by respective filter coefficients, and combining circuits for adding the outputs of the multipliers. In the alternative method the delays 21, 22 together with the delay chain in the adaptive filter are all constituted by a single large area of memory.

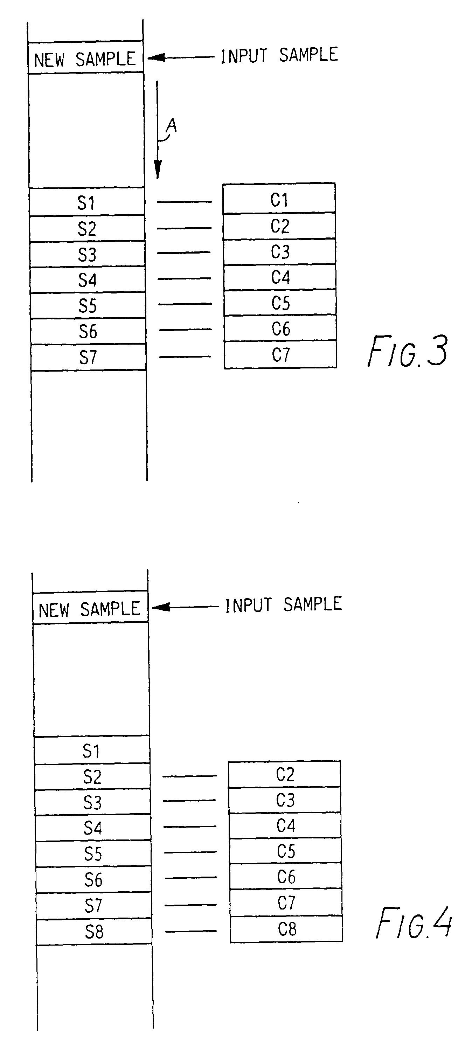

The method is illustrated diagrammatically in Figures 3 and 4. Figure 3 shows the operation of the delay and adaptive canceller prior to a change in delay being required. In this case the filter within the canceller is operating on samples S1 to S7 using adaptive canceller coefficients Cl to C7 respectively (in practice a longer filter length would be employed). Arrow A indicates the direction of effective movement of the samples through the delay and filter memory. Figure 4 illustrates the situation when an increase in overall delay has been detected, and shows the new adaptive canceller coefficients. In this case the start of the window of samples used by the filter is moved from Sl to S2 and the start of the coefficients is similarly moved to C2. The result of this change is that sample Sl and coefficient C1 are no longer used, but sample S8 and new coefficient C8, which is initially set to zero, are now included. Thus the sample and coefficient pairs remain in the same relationship, S2-C2, S3-C3 etc., as before, to minimise any instantaneous disturbance to the output signal as a result of the change. However the overall effect is to move the position of the adaptive canceller within the delay and hence maintain it within its operating range. The new coefficient, in this example C8, although set initially to zero, will be adapted by the canceller as necessary to re-establish the optimum suppression under these new circumstances. This operation of moving the adaptive canceller through the samples within the delay can continue until the correct operating delay for the new situation has been achieved.

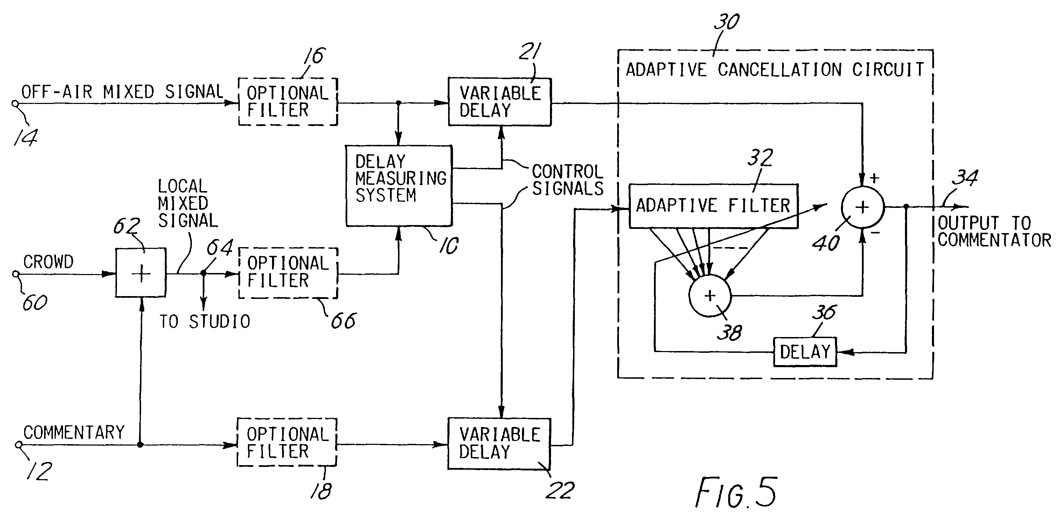

Figure 5 shows a slight modification of the arrangement of Figure 1, and is described in the specific context of an outside broadcast commentator who is commentating on a sports event. As with the Figure 1 system, a feed of the off-air mixed signal is received from the studio as a cue signal at input 14, and the commentary from the commentator's microphone is received at input 12. The output 34 is supplied to the commentator's headphones.

A background signal comprising the outputs of other microphones at the event, which may conveniently be referred to as a "crowd" signal, is received at an input 60, and is combined with the commentary in a combining circuit 62. The output 64 of the combining circuit 62 constitutes the output from the outside broadcast event and may be termed the locally-orginated mixed signal. This signal is fed to the studio.

In the arrangement of Figure 5, the delay measuring system 10 receives the mixed signal from input 14, but instead of receiving the commentary alone from input 12, receives the locally-originated mixed signal from output 64 of the combining circuit 62. An optional filter 66 may be included similar to the filter 18. The delay measuring system 10 provides an output to control the variable delay 22 which receives the signal from input 12 as in Figure 1.

This arrangement works similarly to Figure 1, and retimes the commentary signal so it can cancel the component in the mixed signal feed. However, it allows the delay measurement to be carried out as soon as the locally-originated mixed signal is broadcast. It is not necessary for the system to wait until the commentator starts speaking before it can measure the delay, as in Figure 1. It can therefore achieve more rapid cancellation of the unwanted signal.

The modification shown in Figure 5 can also be used in conjunction with the system shown in Figure 2.

By employing the technique described the systems illustrated are able to track large variations in the relative delay between the applied signals without requiring a large filter in the adaptive canceller 30, consequently avoiding the longer adaption times which would result. If only the adaptive cancellation circuit were used, to accommodate a delay of 500 ms would require 24,000 multipliers and associated combining circuits in the transversal filter 32. By using one of the systems illustrated the adaptive filter 32 need cater for only a very much smaller number of samples, typically 30 to 60 samples.

## Claims

1. A method of attenuating that part of an unwanted audio signal which is included in a mixed audio signal, comprising the steps of:
receiving an unwanted audio signal;
receiving a mixed audio signal which contains the unwanted signal as a part thereof subject to an unknown delay;
measuring and monitoring changes in the time offset between the unwanted audio signal or a signal derived therefrom and the contribution of the unwanted signal in the mixed audio signal;
delaying the unwanted audio signal by substantially the measured time offset to make available a succession of sample values;
subjecting the successive sample values to multiplication by respective coefficients and combining the resultants to provide a filtered signal; and
subtracting the filtered signal from the mixed audio signal, to provide an output signal;
in which the values of the coefficients used are dependent upon the resultant of the subtraction, and the selection of which successive group of sample values the coefficients are to be applied to is dependent upon the resultant of the time offset measurement, whereby the unwanted signal and the part thereof in the mixed signal are maintained substantially co-timed.

2. A method according to claim 1, in which the time offset measurement is effected using phase correlation techniques to identify the relative phase offset at which the maximum correlation arises.

3. A method according to claim 1 or 2, to attenuate a commentary speech signal from a broadcast commentator, the commentary speech signal being included with an unknown delay in a mixed audio signal.

4. Apparatus for attenuating that part of an unwanted audio signal which is included in a mixed audio signal, comprising:
a first input (12) for receiving an unwanted audio signal;
a second input (14) for receiving a mixed audio signal which contains the unwanted audio signal as a part thereof subject to an unknown delay;
time offset measuring means (10) coupled to the first and second inputs for measuring and monitoring changes in the time offset between the unwanted audio signal or a signal derived therefrom and the contribution of the unwanted audio signal in the mixed audio signal;
delay memory means (22) having an input coupled to at least the first input to make available a succession of sample values delayed by substantially said measured time offset ;
combining means (32,38) coupled to the delay memory means to receive selected successive sample values for subjecting the successive sample values to multiplication by respective coefficients and combining the resultants, to provide a filter function to the samples; and
subtractive means (40) coupled to the second input and the output of the combining means to subtract the output signal from the combining circuit from the mixed audio signal, and having an output (34) to provide an output signal;
in which the combining means (32,38) is coupled to the output of the subtractive means (40) such that the values of the coefficients used are dependent upon the output of the subtractive means, and the delay memory means (22) is coupled to the output of the time offset measuring means such that the selection of which successive group of sample values the coefficients are to be applied to is dependent upon the output of the time offset measuring means, whereby the unwanted audio signal and the part thereof in the mixed audio signal are maintained substantially co-timed.

5. Apparatus according to claim 4, in which the time offset measuring means operates using phase correlation techniques to identify the relative phase offset at which the maximum correlation arises.

6. The use of apparatus according to claim 4 or 5, to attenuate a commentary speech signal from a broadcast commentator, the commentary speech signal being included with an unknown delay in a mixed audio signal.

7. A method of attenuating a commentary signal included with an unknown delay in a mixed audio signal, comprising the steps of:
receiving a commentary signal;
receiving a mixed audio signal which contains the commentary signal as a part thereof subject to an unknown delay;
receiving an ambient audio signal;
combining the ambient audio signal with the commentary signal to provide a combined signal;
measuring and monitoring changes in the time offset between the combined signal and the contribution of the commentary and ambient signals in the mixed audio signal;
delaying the commentary signal by substantially said measured time offset to make available a succession of sample values;
subjecting the successive sample values to multiplication by respective coefficients and combining the resultants, to provide a filtered signal; and
subtracting the filtered signal from the mixed audio signal, to provide an output signal.

8. A method according to claim 7, in which the values of the coefficients used are dependent upon the output signal, and the selection of which successive group of sample values the coefficients are to be applied to is dependent upon the result of the time offset measurement.

9. A method according to claim 7 or 8, in which the time offset measurement is effected using phase correlation techniques to identify the relative phase offset at which the maximum correlation arises.

10. Apparatus for attenuating a commentary signal included with an unknown delay in a mixed audio signal, comprising:
a first input (12) for receiving a commentary signal;
a second input (14) for receiving a mixed audio signal which contains the commentary signal as a part thereof subject to an unknown delay;
a third input (60) for receiving an ambient audio signal;
first combining means (62) coupled to the first and third inputs for combining the ambient audio signal with the commentary signal to provide a combined signal;
time offset measuring means (10) coupled to the second input and to the output of the first combining means for measuring and monitoring changes in the time offset between the combined signal and the contribution of the commentary and ambient signals in the mixed audio signal;
delay memory means (22) having an input coupled to the first input to make available a succession of sample values delayed by substantially said measured time offset ;
second combining means (32,38) coupled to the delay memory means to receive selected successive sample values for subjecting the successive sample values to multiplication by respective coefficients and for combining the resultants, and
subtractive means (40) coupled to the second input and the output of the second combining means to subtract the output signal from the second combining circuit from the mixed signal, to provide an output signal.

11. Apparatus according to claim 10, in which the time offset measuring means (10) operates using phase correlation techniques to identify the relative phase offset at which the maximum correlation arises.

12. Apparatus according to claim 10 or 11, in which the second combining means (32,38) is coupled to the output of the subtractive means (40) such that the values of the coefficients used are dependent upon the output of the subtractive means, and the delay memory means (22) is coupled to the output of the time offset measuring means such that the selection of which successive group of sample values the coefficients are to be applied to is dependent upon the output of the time offset measuring means.

## Patentansprüche

1. Verfahren zum Dämpfen desjenigen Teils eines unerwünschten Tonsignals, das in einem Mischtonsignal enthalten ist, umfassend die folgenden Schritte:
Empfangen eines unerwünschten Tonsignals;
Empfangen eines Mischtonsignals, das das unerwünschte Signal als Bestandteil aufweist, mit einer unbekannten Verzögerung;
Messen und Überwachen von Änderungen im zeitlichen Versatz zwischen dem unerwünschten Tonsignal oder einem davon abgeleiteten Signal und dem Anteil des unerwünschten Signals am Mischtonsignal;
Verzögern des unerwünschten Tonsignals im wesentlichen um den gemessenen zeitlichen Versatz, um eine Folge von Abtastwerten zu erhalten;
Multiplizieren der aufeinanderfolgenden Abtastwerte mit jeweiligen Koeffizienten und Kombinieren der Ergebnisse zum Erhalten eines gefilterten Signals; und
Subtrahieren des gefilterten Signals von dem Mischtonsignal zum Erhalten eines Ausgangssignals;
wobei die Werte der verwendeten Koeffizienten abhängig sind vom Ergebnis der Subtraktion, und die Wahl, auf welche aufeinanderfolgende Gruppe von Abtastwerten die Koeffizienten angewendet werden sollen, abhängig ist vom Ergebnis der Messung des zeitlichen Versatzes, so daß das unerwünschte Signal und der Bestandteil davon am Mischsignal im wesentlichen gleichzeitig gehalten werden.

2. Verfahren nach Anspruch 1, bei dem die Messung des zeitlichen Versatzes mit Hilfe von Phasenkorrelationstechniken erfolgt, um den relativen Phasenversatz zu identifizieren, bei dem die maximale Korrelation entsteht.

3. Verfahren nach Anspruch 1 oder 2 zum Dämpfen eines Kommentarsprachsignals von einem Rundfunkkommentator, wobei das Kommentarsprachsignal mit einer unbekannten Verzögerung in einem Mischtonsignal enthalten ist.

4. Vorrichtung zum Dämpfen desjenigen Teils eines unerwünschten Tonsignals, das in einem Mischtonsignal enthalten ist, umfassend:
einen ersten Eingang (12) zum Empfangen eines unerwünschten Tonsignals;
einen zweiten Eingang (14) zum Empfangen eines Mischtonsignals, das das unerwünschte Tonsignal als Bestandteil enthält, mit einer unbekannten Verzögerung;
ein Mittel (10) zum Messen des zeitlichen Versatzes, das mit dem ersten und dem zweiten Eingang zum Messen und Überwachen von Änderungen des zeitlichen Versatzes zwischen dem unerwünschten Tonsignal oder einem davon abgeleiteten Signal und dem Anteil des unerwünschten Tonsignals am Mischtonsignal gekoppelt ist;
ein Verzögerungsspeichermittel (22) mit einem Eingang, der wenigstens mit dem ersten Eingang gekoppelt ist, um eine Folge von Abtastwerten zu erhalten, die im wesentlichen um den genannten gemessenen zeitlichen Versatz verzögert sind;
ein Kombinationsmittel (32, 38), das mit dem Verzögerungsspeichermittel gekoppelt ist, um gewählte aufeinanderfolgende Abtastwerte zu empfangen, zum Multiplizieren aufeinanderfolgender Abtastwerte mit jeweiligen Koeffizienten und zum Kombinieren der Ergebnisse, um eine Filterfunktion für die Proben bereitzustellen; und
ein Subtraktionsmittel (40), das mit dem zweiten Eingang und dem Ausgang des Kombinationsmittels gekoppelt ist, um das Ausgangssignal von der Kombinationsschaltung von dem Mischtonsignal zu subtrahieren, und das einen Ausgang (34) hat, um ein Ausgangssignal zu erzeugen;
wobei das Kombinationsmittel (32, 38) mit dem Ausgang des Subtraktionsmittels (40) gekoppelt ist, so daß die Werte der verwendeten Koeffizienten vom Ausgang des Subtraktionsmittels abhängig sind, und das Verzögerungsspeichermittel (22) mit dem Ausgang des Mittels zum Messen des zeitlichen Versatzes gekoppelt ist, so daß die Auswahl, auf welche aufeinanderfolgende Gruppe von Probenwerten die Koeffizienten angewendet werden sollen, abhängig ist vom Ausgang des Mittels zum Messen des zeitlichen Versatzes, so daß das unerwünschte Tonsignal und dessen Bestandteil im Mischtonsignal im wesentlichen gleichzeitig gehalten werden.

5. Vorrichtung nach Anspruch 4, bei der das Mittel zum Messen des zeitlichen Versatzes mit Phasenkorrelationstechniken arbeitet, um den relativen Phasenversatz zu identifizieren, bei dem die maximale Korrelation entsteht.

6. Verwendung der Vorrichtung nach Anspruch 4 oder 5, um ein Kommentarsprachsignal von einem Rundfunkkommentator zu dämpfen, wobei das Kommentarsprachsignal mit einer unbekannten Verzögerung in einem Mischtonsignal enthalten ist.

7. Verfahren zum Dämpfen eines Kommentarsignals, das mit einer unbekannten Verzögerung in einem Mischtonsignal enthalten ist, umfassend die folgenden Schritte:
Empfangen eines Kommentarsignals;
Empfangen eines Mischtonsignals, das das Kommentarsignal als Bestandteil davon enthält, mit einer unbekannten Verzögerung;
Empfangen eines Umgebungstonsignals;
Kombinieren des Umgebungstonsignals mit dem Kommentarsignal zur Erzeugung eines kombinierten Signals;
Messen und Überwachen von Änderungen des zeitlichen Versatzes zwischen dem kombinierten Signal und dem Anteil der Kommentar- und Umgebungssignale am Mischtonsignal;
Verzögern des Kommentarsignals um im wesentlichen den genannten gemessenen zeitlichen Versatz, um eine Folge von Abtastwerten verfügbar zu machen;
Multiplizieren der aufeinanderfolgenden Abtastwerte mit jeweiligen Koeffizienten und Kombinieren der Ergebnisse, um ein gefiltertes Signal zu erhalten; und
Subtrahieren des gefilterten Signals von dem Mischtonsignal, um ein Ausgangssignal zu erhalten.

8. Verfahren nach Anspruch 7, bei dem die Werte der verwendeten Koeffizienten abhängig sind vom Ausgangssignal, und wobei die Wahl, auf welche aufeinanderfolgende Gruppe von Abtastwerten die Koeffizienten angewendet werden sollen, abhängig ist vom Ergebnis der Messung des zeitlichen Versatzes.

9. Verfahren nach Anspruch 7 oder 8, bei dem die Messung des zeitlichen Versatzes mit Phasenkorrelationstechniken erfolgt, um den relativen Phasenversatz zu identifizieren, an dem die maximale Korrelation entsteht.

10. Vorrichtung zum Dämpfen eines Kommentarsignals, das mit einer unbekannten Verzögerung in einem Mischtonsignal enthalten ist, umfassend:
einen ersten Eingang (12) zum Empfangen eines Kommentarsignals;
einen zweiten Eingang (14) zum Empfangen eines Mischtonsignals, das das Kommentarsignal als Bestandteil enthält, mit einer unbekannten Verzögerung;
einen dritten Eingang (60) zum Empfangen eines Umgebungstonsignals;
ein erstes Kombinationsmittel (62), das mit dem ersten und dem dritten Eingang gekoppelt ist, um das Umgebungstonsignal mit dem Kommentarsignal zu kombinieren, so daß ein kombiniertes Signal entsteht;
ein Mittel (10) zum Messen des zeitlichen Versatzes, das mit dem zweiten Eingang und dem Ausgang des ersten Kombinationsmittels gekoppelt ist, um Änderungen des zeitlichen Versatzes zwischen dem kombinierten Signal und den Anteilen der Kommentar- und Umgebungssignale an dem Mischtonsignal zu messen und zu überwachen;
Verzögerungsspeichermittel (22) mit einem Eingang, der mit dem ersten Eingang gekoppelt ist, um eine Folge von Abtastwerten zu erhalten, verzögert im wesentlichen um den genannten gemessenen zeitlichen Versatz;
ein zweites Kombinationsmittel (32, 38), das mit dem Verzögerungsspeichermittel gekoppelt ist, um gewählte aufeinanderfolgende Abtastwerte zu empfangen, um die aufeinanderfolgenden Abtastwerte mit jeweiligen Koeffizienten zu multiplizieren und die Ergebnisse zu kombinieren, und
ein Subtraktionsmittel (40), das mit dem zweiten Eingang und dem Ausgang des zweiten Kombinationsmittels gekoppelt ist, um das Ausgangssignal von der zweiten Kombinationsschaltung von dem Mischsignal zu subtrahieren, so daß ein Ausgangssignal entsteht.

11. Vorrichtung nach Anspruch 10, bei der das Mittel (10) zum Messen des zeitlichen Versatzes mit Phasenkorrelationstechniken arbeitet, um den relativen Phasenversatz zu erkennen, bei dem die maximale Korrelation entsteht.

12. Vorrichtung nach Anspruch 10 oder 11, bei dem das zweite Kombinationsmittel (32, 38) mit dem Ausgang des Subtraktionsmittels (40) gekoppelt ist, so daß die Werte der verwendeten Koeffizienten abhängig sind vom Ausgang des Subtraktionsmittels, und das Verzögerungsspeichermittel (22) mit dem Ausgang des Mittels zum Messen des zeitlichen Versatzes gekoppelt ist, so daß die Wahl, auf welche aufeinanderfolgende Gruppe von Abtastwerten die Koeffizienten angewendet werden sollen, abhängig ist vom Ausgang des Mittels zum Messen des zeitlichen Versatzes.

## Revendications

1. Procédé d'atténuation de la partie d'un signal audio indésirable qui est inclus dans un signal audio mixte, comprenant les étapes de :
réception d'un signal audio indésirable ;
réception d'un signal audio mixte qui contient le signal indésirable comme partie de celui-ci soumis à un retard inconnu ;
mesure et contrôle des changements du décalage de temps entre le signal audio indésirable ou un signal dérivé de celui-ci et la contribution du signal indésirable dans le signal audio mixte ;
retard du signal audio indésirable sensiblement par le décalage de temps mesuré en vue de produire une succession de valeurs d'échantillons ;
soumission des valeurs d'échantillons successives à une multiplication par des coefficients respectifs et combinaison des résultats en vue de fournir un signal filtré ; et
soustraction du signal filtré à partir du signal audio mixte, en vue de fournir un signal de sortie ;
dans lequel les valeurs des coefficients utilisés dépendent du résultat de la soustraction, et la sélection du groupe successif de valeurs d'échantillons auquel les coefficients doivent être appliqués dépend du résultat de la mesure de décalage de temps, si bien que le signal indésirable et la partie de celui-ci dans le signal mixte sont maintenus sensiblement dans le même temps.

2. Procédé selon la revendication 1, dans lequel la mesure de décalage de temps est effectuée en utilisant des techniques de corrélation de phase en vue d'identifier le décalage de phase relatif auquel se produit la corrélation maximum.

3. Procédé selon la revendication 1 ou 2, en vue d'atténuer un signal de parole de commentaire d'un commentateur de diffusion, le signal de parole de commentaire étant inclus avec un retard inconnu dans un signal audio mixte.

4. Appareil pour atténuer la partie d'un signal audio indésirable qui est incluse dans un signal audio mixte, comprenant :
une première entrée (12) pour recevoir un signal audio indésirable ;
une deuxième entrée (14) pour recevoir un signal audio mixte qui contient le signal audio indésirable comme partie de celui-ci soumis à un retard inconnu ;
un moyen de mesure de décalage de temps (10) couplé aux première et deuxième entrées pour mesurer et contrôler les changements du décalage de temps entre le signal audio indésirable ou un signal dérivé de celui-ci et la contribution du signal audio indésirable dans le signal audio mixte ;
un moyen de mémoire de retard (22) ayant une entrée couplée à au moins la première entrée pour produire une succession de valeurs d'échantillons retardées par sensiblement ledit décalage de temps mesuré ;
un moyen de combinaison (32, 38) couplé au moyen de mémoire de retard en vue de recevoir des valeurs d'échantillons successives sélectionnées pour soumettre les valeurs d'échantillons successives à une multiplication par des coefficients respectifs et combiner les résultats en vue de fournir une fonction de filtrage aux échantillons ; et
un moyen de soustraction (40) couplé à la deuxième entrée et à la sortie du moyen de combinaison en vue de soustraire le signal de sortie du circuit de combinaison à partir du signal audio mixte, et ayant une sortie (34) en vue de fournir un signal de sortie ;
dans lequel le moyen de combinaison (32, 38) est couplé à la sortie du moyen de soustraction (40) de telle sorte que les valeurs des coefficients utilisés dépendent de la sortie du moyen de soustraction, et le moyen de mémoire de retard (22) est couplé à la sortie du moyen de mesure de décalage de temps de telle sorte que la sélection du groupe successif de valeurs d'échantillons auquel les coefficients doivent être appliqués dépende de la sortie du moyen de mesure de décalage de temps, si bien que le signal indésirable et la partie de celui-ci dans le signal audio mixte sont maintenus sensiblement dans le même temps.

5. Appareil selon la revendication 4, dans lequel le moyen de mesure de décalage de temps fonctionne en utilisant des techniques de corrélation de phase en vue d'identifier le décalage de phase relatif auquel se produit la corrélation maximum.

6. Utilisation de l'appareil selon la revendication 4 ou 5, en vue d'atténuer un signal de parole de commentaire d'un commentateur de diffusion, le signal de parole de commentaire étant inclus avec un retard inconnu dans un signal audio mixte.

7. Procédé d'atténuation d'un signal de commentaire inclus avec un retard inconnu dans un signal audio mixte, comprenant les étapes de :
réception d'un signal de commentaire ;
réception d'un signal audio mixte qui contient le signal de commentaire comme partie de celui-ci soumis à un retard inconnu ;
réception d'un signal audio ambiant ;
combinaison du signal audio ambiant avec le signal de commentaire en vue de fournir un signal combiné ;
mesure et contrôle des changements du décalage de temps entre le signal combiné et la contribution des signaux de commentaire et ambiant dans le signal audio mixte ;
retard du signal de commentaire sensiblement par ledit décalage de temps mesuré en vue de produire une succession de valeurs d'échantillons ;
soumission des valeurs d'échantillons successives à une multiplication par des coefficients respectifs et combinaison des résultats, en vue de fournir un signal filtré ; et
soustraction du signal filtré à partir du signal audio mixte, en vue de fournir un signal de sortie.

8. Procédé selon la revendication 7, dans lequel les valeurs des coefficients utilisés dépendent du signal de sortie, et la sélection du groupe successif de valeurs d'échantillons auquel les coefficients doivent être appliqués dépend du résultat de la mesure de décalage de temps.

9. Procédé selon la revendication 7 ou 8, dans lequel la mesure de décalage de temps est effectuée en utilisant des techniques de corrélation de phase en vue d'identifier le décalage de phase relatif auquel se produit la corrélation maximum.

10. Appareil pour atténuer un signal de commentaire inclus avec un retard inconnu dans un signal audio mixte, comprenant :
une première entrée (12) pour recevoir un signal de commentaire ;
une deuxième entrée (14) pour recevoir un signal audio mixte qui contient le signal de commentaire comme partie de celui-ci sous réserve d'un retard inconnu ;
une troisième entrée (60) pour recevoir un signal audio ambiant ;
un premier moyen de combinaison (62) couplé aux première et troisième entrées pour combiner le signal audio ambiant au signal de commentaire en vue de fournir un signal combiné ;
un moyen de mesure de décalage de temps (10) couplé à la deuxième entrée et à la sortie du premier moyen de combinaison pour mesurer et contrôler les changements du décalage de temps entre le signal combiné et la contribution des signaux de commentaire et ambiant dans le signal audio mixte ;
un moyen de mémoire de retard (22) ayant une entrée couplée à la première entrée pour produire une succession de valeurs d'échantillons retardées par sensiblement ledit décalage de temps mesuré ;
un deuxième moyen de combinaison (32, 38) couplé au moyen de mémoire de retard en vue de recevoir des valeurs d'échantillons successives sélectionnées pour soumettre les valeurs d'échantillons successives à une multiplication par des coefficients respectifs et combiner les résultats ; et
un moyen de soustraction (40) couplé à la deuxième entrée et à la sortie du deuxième moyen de combinaison en vue de soustraire le signal de sortie du deuxième circuit de combinaison à partir du signal audio mixte, en vue de fournir un signal de sortie.

11. Appareil selon la revendication 10, dans lequel le moyen de mesure de décalage de temps (10) fonctionne en utilisant des techniques de corrélation de phase en vue d'identifier le décalage de phase relatif auquel se produit la corrélation maximum.

12. Appareil selon la revendication 10 ou 11, dans lequel le deuxième moyen de combinaison (32, 38) est couplé à la sortie du moyen de soustraction (40) de telle sorte que les valeurs des coefficients utilisés dépendent de la sortie du moyen de soustraction, et le moyen de mémoire de retard (22) est couplé à la sortie du moyen de mesure de décalage de temps de telle sorte que la sélection du groupe successif de valeurs d'échantillons auquel les coefficients doivent être appliqués dépende de la sortie du moyen de mesure de décalage de temps.
